# FASCICULE DE BREVET EUROPEEN

(11) **EP 0 476 302 B1**
(45) Date de publication et mention de la délivrance du brevet: **05.11.1997**
(21) Numéro de dépôt: 91113574.7
(22) Date de dépôt: 13.08.1991
(51) Int. Cl.: H03G 3/20, H03G 3/00

(54) **Procédé et dispositif de commande automatique de gain d'un amplificateur à gain variable, et leur application à la commande de gain d'un syntoniseur, notamment pour réseau de vidéocommunication**
Verfahren und Vorrichtung zur automatischen Steuerung der Verstärkung eines Verstärkers und die Verwendung dieses Verfahrens und dieser Vorrichtung bei der Verstärkungssteuerung eines Tuners, insbesondere eines Tuners für ein Videokommunikationsnetz
Method and device for automatic gain control of amplifier, and application for the gain control of a tuner, particularly for videocommunication networks

(30) Priorité: 14.08.1990 FR 9010331
(43) Date de publication de la demande: 25.03.1992
(73) Titulaire: ALCATEL CIT, 75008 Paris (FR)
(72) Inventeur: Bureau, Christophe, F-92220 Bagneux (FR); Ruggeri, Stéphane, F-78114 Magny Les Hameaux (FR)
(74) Mandataire: Sciaux, Edmond

(56) Documents cités:
- EP-A- 086 514
- EP-A- 0 119 791
- WO-A-80/01632
- DE-A- 3 346 678
- GB-A- 2 146 191
- US-A- 4 112 384
- US-A- 4 704 584

## Description

La présente invention telle qu'elle est définie dans les revendications concerne un procédé et un dispositif de commande automatique de gain d'un amplificateur à gain variable, destinés plus particulièrement à maintenir le niveau du signal de sortie de cet amplificateur à une valeur souhaitée.

La présente invention est notamment applicable à un réseau de vidéocommunication, plus particulièrement à des équipements dits de distribution d'un tel réseau, qui reçoivent d'un équipement dit d'émission un ensemble de N signaux de télévision, ou canaux, multiplexés en fréquence et transmis chacun par modulation d'amplitude d'une porteuse de fréquence déterminée, et qui assurent l'émission, sur différentes fibres optiques desservant respectivement différents abonnés de ce réseau, des différents canaux respectivement sélectionnés à tout moment par ces abonnés.

Ces équipements de distribution comportent un syntoniseur qui réalise lui-même d'une part une fonction de sélection de canal et de transposition à fréquence intermédiaire du canal sélectionné, et d'autre part une fonction d'amplification.

La nécessité d'effectuer une commande automatique du gain de l'amplificateur réalisant cette amplification est due notamment au fait que le niveau de la porteuse des différents canaux reçus en entrée du syntoniseur est variable dans le temps ainsi que d'un canal à l'autre, une telle variation d'un canal à l'autre pouvant également être induite par la réponse en fréquence de ce syntoniseur.

Il est connu, de façon générale, pour réaliser une commande automatique de gain d'un amplificateur à gain variable, de mettre en oeuvre, de façon analogique ou numérique, une méthode dite par incréments consistant, après application d'une valeur initiale d'un signal de commande à l'entrée de commande de gain de cet amplificateur, à ajuster progressivement la valeur de ce signal de commande en fonction du niveau de sortie observé correspondant, jusqu'à obtenir le niveau de sortie souhaité.

Cette méthode a notamment pour inconvénient de présenter un temps de convergence relativement long, incompatible avec certaines applications telles que l'application à un réseau de vidéocommunication évoquée ci-dessus, où il est en effet nécessaire de retrouver quasi-instantanément une même qualité d'image chez un abonné du réseau, en particulier lors d'un changement de canal.

Le document EP 0 086 514 décrit un procédé de commande automatique de gain, comportant les opérations suivantes :
- appliquer à l'amplificateur une valeur mémorisée du signal de commande de gain, cette valeur étant celle déterminée pour le canal considéré, la dernière fois où il a été utilisé,
- mesurer le niveau de sortie de l'amplificateur, par un dispositif de mesure ayant une caractéristique approximativement logarithmique, et fournissant une valeur appelée niveau de sortie mesuré;
- calculer la différence entre le niveau de sortie mesuré et un niveau fixé qui est égal au niveau de sortie qui serait mesuré si la sortie de l'amplificateur fournissait le niveau de sortie souhaité, cette différence constituant un premier signal de correction du signal de commande;
- corriger le signal de commande, de façon à réduire cette différence, en additionnant au signal de commande un second signal de correction qui est fonction à la fois du premier signal de correction, et de la valeur du signal de commande lui-même;
- mémoriser la valeur corrigé du signal de commande, à la place de la valeur courante.

Les valeurs du second signal de correction sont mémorisées dans une mémoire morte et ont été déterminées expérimentalement de façon à compenser les imperfections de la chaîne d'amplification et de mesure. Les valeurs du second signal de correction permettent d'obtenir le niveau de sortie souhaité, bien que le gain de l'amplificateur, en décibels, ne soit pas une fonction parfaitement linéaire du signal de commande de gain, et bien que le gain du dispositif de mesure ne soit pas parfaitement logarithmique.

Ce procédé présente l'inconvénient de nécessiter une mémoire morte stockant de très nombreuses valeurs pour le second signal de correction. En effet, elle doit comporter une pluralité de zones correspondant à une pluralité de valeurs du signal de commande, chaque zone stockant une pluralité de valeurs du second signal de correction, parce qu'il faut une loi de correction différente pour chaque valeur du signal de commande. Autrement dit, quand le canal change, la valeur mémorisée pour le signal de commande de gain change, et il faut utiliser une nouvelle loi de correction pour corriger les imperfections de la chaîne d'amplification et de mesure, autour de ce point de fonctionnement.

Le but de l'invention est de proposer un procédé permettant d'éviter de stocker une loi de correction différente pour chaque valeur du signal de commande de gain.

L'objet de l'invention est un procédé de commande automatique de gain, pour amplificateur à gain variable, destiné à maintenir le niveau du signal de sortie de cet amplificateur égal à un niveau souhaité, consistant à :
- appliquer à l'amplificateur une valeur courante du signal de commande de gain;
- mesurer le niveau de sortie de l'amplificateur, par un dispositif de mesure ayant une caractéristique non linéaire, et fournissant une valeur appelée niveau de sortie mesuré;
- détecter un éventuel écart entre le niveau de sortie mesuré et un niveau fixé qui est égal au niveau de sortie qui serait mesuré si la sortie de l'amplificateur fournissait le niveau de sortie souhaité;
- et, si cet écart n'est pas négligeable, corriger le signal de commande, de façon à réduire cet écart;
caractérisé en ce que pour corriger le signal de commande de façon à réduire cette différence, il consiste à :
- rechercher selon une première relation ayant été prédéterminée par un étalonnage, un niveau d'entrée, ou une première valeur théorique du signal de commande, correspondant, en sortie de l'amplificateur, à un niveau de sortie mesuré égal à celui effectivement mesuré;
- puis rechercher selon une seconde relation ayant été prédéterminée par un étalonnage, une seconde valeur théorique du signal de commande, correspondant au niveau d'entrée, respectivement à la première valeur théorique du signal de commande, ainsi déterminé;
- mettre à jour la valeur courante de signal de commande en prenant la second valeur théorique ainsi déterminée;

L'invention a aussi pour objet un dispositif pour la mise en oeuvre de ce procédé.

Le procédé ainsi caractérisé présente l'avantage d'être plus Le procédé ainsi caractérisé présente l'avantage d'être plus facile à mettre en oeuvre parce qu'il ne nécessite la mémorisation que de deux lois de variation, alors que le dispositif connu décrit dans le document EP 0 086 514 nécessite de mémoriser un nombre de lois toujours nettement supérieur à deux.

D'autres objets et caractéristiques de la présente invention apparaîtront à la lecture de la description suivante d'un exemple de réalisation, faite en relation avec les dessins ci-annexés dans lesquels :
- la figure 1 représente un schéma synoptique d'un dispositif de mise en oeuvre d'un procédé suivant l'invention, dans le cadre de l'application de ce procédé à un réseau de vidéocommunication, telle qu'indiquée ci-dessus,
- les figures 2 et 3 représentent respectivement un exemple de loi de variation des grandeurs appelées tension de consigne et tension détectée, telles qu'acquises au cours de la phase dite d'étalonnage du procédé suivant l'invention,
- la figure 4 représente un organigramme destiné à illustrer le traitement mis en oeuvre au cours de la phase opératoire du procédé suivant l'invention.

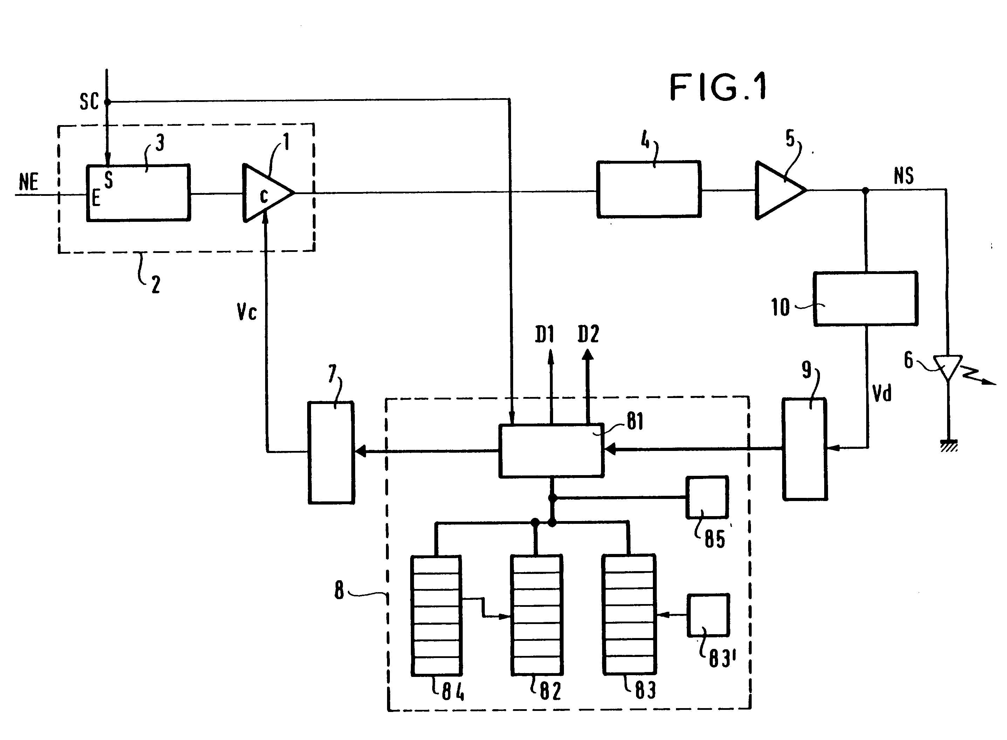

Sur la figure 1 est référencé 1 un amplificateur à gain variable inclus dans un syntoniseur 2 comportant également, en amont de l'amplificateur 1, un sélecteur 3 d'un canal parmi N canaux formant un multiplex fréquentiel reçu à une entrée E de ce sélecteur, ce dernier étant en outre muni d'une entrée S de sélection de canal sur laquelle est appliqué un signal SC de commande de sélection de canal.

A titre d'exemple, dans le cadre de l'application précitée à un réseau de vidéocommunication, le nombre N est par exemple égal à 30 et chaque canal est transmis par modulation d'amplitude d'une porteuse propre à ce canal, l'ensemble de ces porteuses occupant une bande de fréquences de 136 à 360 MHz avec des pas de 8 MHz.

Le sélecteur 3 réalise également une transposition à fréquence intermédiaire du canal sélectionné, cette fréquence intermédiaire étant, pour la même application, égale à 38,9 MHz.

Le syntoniseur 2 est, dans cette application, suivi d'un filtre 4 permettant de délimiter la bande passante du canal sélectionné et transposé, suivi lui-même d'un amplificateur 5 à fréquence intermédiaire, suivi à son tour d'une diode électroluminescente 6 qui fournit le signal transmis par fibre optique à destination d'un abonné du réseau considéré.

L'amplificateur à gain variable 1 est muni d'une entrée C de commande de gain sur laquelle est appliquée une tension de consigne Vc obtenue en sortie d'un convertisseur numérique - analogique 7 qui reçoit lui-même d'un processeur 8 un signal numérique correspondant.

Le processeur 8 reçoit lui-même d'une part le signal de sélection de canal SC et d'autre part, via un convertisseur analogique - numérique 9, le signal de sortie d'un moyen de mesure, ou détecteur, 10, qui a en l'occurrence une fonction de transfert non linéaire et qui convertit le signal appliqué à son entrée en une tension continue Vd représentant le niveau de ce signal. En l'occurrence le signal appliqué à l'entrée du détecteur 10 est le signal de sortie de la chaîne complète formée du syntoniseur 2, du filtre 4 et de l'amplificateur à fréquence intermédiaire 5, et non directement le signal de sortie du syntoniseur, afin d'intégrer également à cette commande automatique de gain d'éventuelles dérives du niveau de sortie de la chaîne dues aux éléments 4 et 5.

Le détecteur 10 effectue en l'occurrence une détection du niveau des signaux de synchronisation de ligne transmis au cours des périodes de synchronisation correspondantes des signaux de télévision, c'est-à-dire de la porteuse non modulée correspondante transmise au cours de ces périodes, et possède par conséquent à la fois une rapidité et une capacité de mémorisation suffisantes pour effectuer une telle détection, ces périodes de synchronisation étant très brèves, d'une durée de l'ordre d'une dizaine de microsecondes, et de périodicité pouvant allant jusqu'à quelques dizaines de millisecondes en fonction du code utilisé (D2MAC, SECAM,...).

Le processeur 8 comporte une unité de traitement 81 associée à des mémoires mortes 82,83 , 83' et à des mémoires vives 84,85, les mémoires mortes 82 et 83 étant dites respectivement mémoire de tensions de consigne et mémoire de tensions détectées, et contenant respectivement une table dite de tensions de consigne et une table dite de tensions détectées, établies lors d'une phase d'étalonnage préalable.

Dans l'application considérée, la commande automatique de gain de l'amplificateur 1 est destinée à maintenir le niveau de sortie N_{S} de cette chaîne à une valeur souhaitée N_{SO} égale par exemple à -3dBm, quel que soit le canal sélectionné et quelles que soient les éventuelles variations dans le temps du niveau N_{E} de signal de ce canal à l'entrée du syntoniseur, les dispersions de niveau de signal à l'entrée de la chaine se situant en l'occurrence dans une plage de ± 4 dB autour d'une valeur nominale N_{EO} égale par exemple à - 37 dBm.

La table de tensions de consigne est en l'occurrence obtenue en faisant varier le niveau d'entrée N_{E} par pas de "n" dB, dans la plage de variations considérée, et en notant à chaque fois la valeur de tension de consigne Vc qu'il est nécessaire d'appliquer à l'entrée C de commande de gain de l'amplificateur 1 pour maintenir, pour un canal sélectionné déterminé, quelconque, le niveau de sortie N_{S} à la valeur souhaitée N_{SO}. A titre d'exemple la valeur "n" peut être choisie égale à 0,5.

La table de tensions de consigne pourrait également être obtenue en appliquant un niveau d'entrée N_{E} constant et en notant les différentes valeurs de tension de consigne Vc, dans la plage de variation de celle-ci, qui, appliquées à l'entrée de commande C de l'amplificateur 1, permettent d'obtenir un niveau de sortie N_{S} variant par pas de "n" dB.

La table de tensions détectées est en l'occurrence obtenue en notant les différentes tensions détectées Vd obtenues en sortie du détecteur 10 pour différents niveaux d'entrée de ce détecteur variant par pas de "n" dB dans la plage de variation du niveau de sortie N_{S} .

Ces variations du niveau d'entrée du détecteur peuvent être obtenues soit en faisant varier le niveau d'entrée N_{E} , à tension de consigne Vc constante, soit en faisant varier la tension de consigne Vc à niveau d'entrée N_{E} constant.

Pour simplifier, un signal d'entrée du syntoniseur consistant en une sinusoïde continue de fréquence correspondant à la fréquence porteuse d'un canal sélectionné peut être utilisé au cours de cette phase d'étalonnage.

Cette phase d'étalonnage comporte par ailleurs avantageusement un réglage préalable du gain de la chaîne formée par le syntoniseur 2, le filtre 4 et l'amplificateur à fréquence intermédiaire 5, en l'occurrence un réglage préalable du gain de l'amplificateur à fréquence intermédiaire 5, de façon à adapter la dynamique de variation du niveau du signal d'entrée de cette chaîne à la dynamique de variation du gain de l'amplificateur à gain variable 1.

En l'occurrence, cette adaptation se fait de façon à obtenir la valeur souhaitée N_{SO} en sortie de cette chaîne pour une valeur de tension de consigne maximale, par exemple 10 Volts, et pour les conditions les plus défavorables en entrée, soit un canal sélectionné correspondant à l'atténuation maximale apportée par la réponse amplitude fréquence du syntoniseur et un niveau de signal pour ce canal à l'entrée de cette chaîne égal à la valeur minimale N_{Em} ( soit dans l'exemple considéré - 4 dB par rapport à la valeur nominale N_{Eo}).

Après ce réglage préalable, effectué en boucle ouverte , on procède à l'établissement, également en boucle ouverte, des tables de tensions de consigne et de tensions détectées, comme indiqué ci-dessus.

Les différentes valeurs de tension de consigne, obtenues en l'occurrence pour un niveau d'entrée croissant par pas de 0,5 dB, et converties en numérique, sont stockées à des adresses successives de la mémoire de tensions de consigne 82, chaque adresse étant définie par ajout à l'adresse précédente d'un pas d'adressage "p" fixe, égal par exemple à 1 en valeur décimale.

La mémoire de tensions de consigne 82 est par ailleurs associée à un pointeur, correspondant en l'occurrence à l'une des cases-mémoire de la mémoire vive 84, dite mémoire de pointeurs, et indiquant, de la manière symbolisée par une flèche sur la figure 1, celle des adresses de la mémoire de tensions de consigne 82 contenant la valeur courante de tension de consigne à appliquer, en phase opératoire, c'est-à-dire en boucle fermée, à l'entrée de commande de gain de l'amplificateur 1 pour obtenir la valeur de sortie N_{SO} souhaitée.

Chacune des cases-mémoire de la mémoire de pointeurs 84 est associée à un canal déterminé et indique ainsi l'adresse de la mémoire de tensions de consigne 82 contenant la valeur de tension de consigne à appliquer, en boucle fermée, à l'amplificateur 1, pour obtenir, pour le canal considéré, la valeur de sortie N_{SO} souhaitée.

Le contenu de la mémoire de pointeurs 84 est mis à jour en permanence, au cours de la phase opératoire, ainsi qu'il sera vu ultérieurement et son contenu initial est avantageusement déterminé, à l'initialisation de cette phase opératoire, par mise en oeuvre, en boucle fermée, de l'algorithme de traitement caractéristique de cette phase opératoire, tel que décrit ultérieurement, et à partir d'un contenu à priori quelconque de cette mémoire de pointeurs 84.

De même, les valeurs de tensions détectées Vd obtenues pour un niveau d'entrée du détecteur croissant en l'occurrence par pas de 0,5 dB, et converties en numérique, sont stockées à des adresses successives de la mémoire de tensions détectées 83, chaque adresse étant également définie par ajout à l'adresse précédente d'un pas d'adressage "p" fixe, égal à celui choisi pour la mémoire de tensions de consigne 82, égal par exemple à 1 en valeur décimale.

La mémoire de tensions détectées 83 est également associée à un pointeur, constitué par un registre 83' et indiquant, de la manière symbolisé par une flèche sur la figure 1, celle de ses adresses, référencée ADR Vdₒ, qui correspond à une tension détectée Vdₒ correspondant elle-même à un niveau N_{S} de sortie de cette chaîne de valeur égale à la valeur souhaitée N_{SO} .

La loi de variation de la tension détectée Vd en fonction du niveau de sortie de cette chaîne et la loi de variation de la tension de consigne Vc en fonction du niveau d'entrée du syntoniseur sont ainsi établies sous forme discrète et stockées dans les mémoires mortes 82 et 83. Dans le cas où l'une de ces lois ou les deux s'exprimeraient sous une forme mathématique se prêtant au calcul par microprocesseur, la mémoire ou les mémoires correspondantes pourraient être supprimées et l'expression mathématique ou les expressions mathématiques correspondantes calculées directement par l'unité de traitement 81.

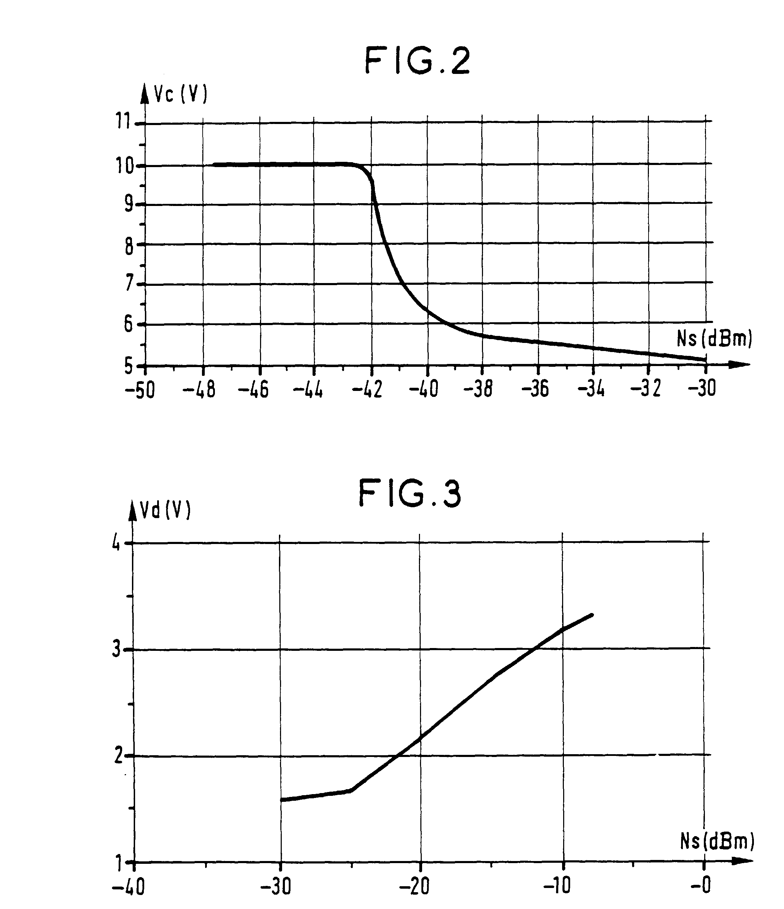

A titre d'exemple, on a représenté, respectivement sur les figures 2 et 3, des exemples de courbes illustrant ces lois de variation.

La loi de variation de la tension de consigne étant par ailleurs susceptible de varier d'un syntoniseur à l'autre, il peut être nécessaire de déterminer la table ou la fonction mathématique correspondante pour chaque syntoniseur. Il en est de même pour la loi de variation de la tension détectée susceptible de varier d'un détecteur à l'autre.

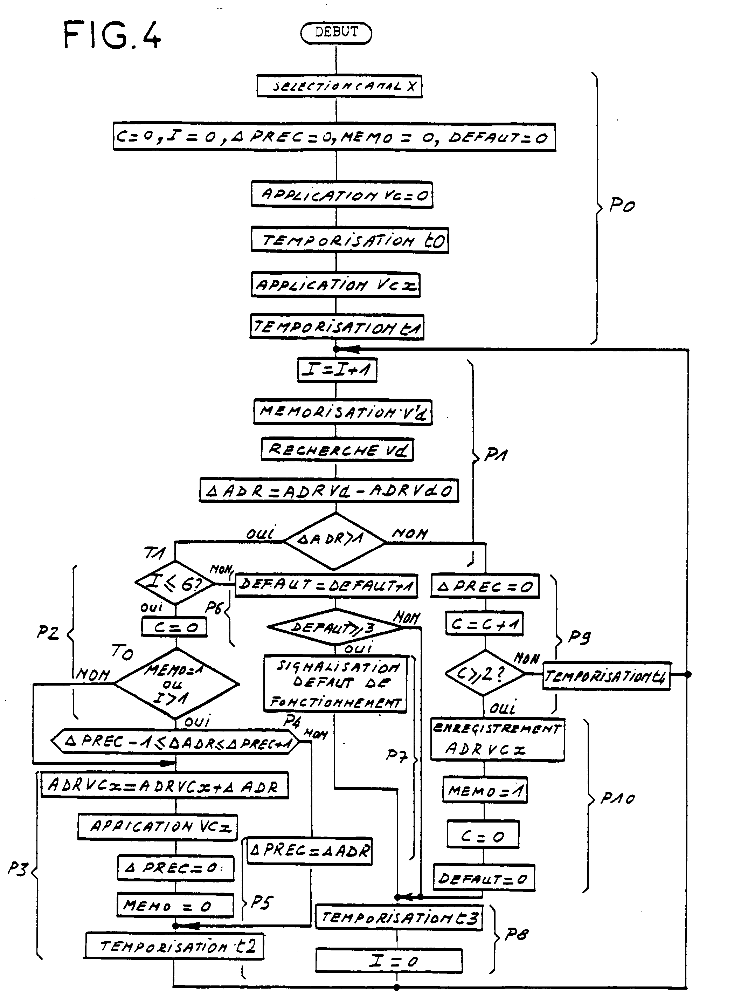

On décrit maintenant, en relation avec l'organigramme de la figure 4, le traitement mis en oeuvre par l'unité de traitement 81 au cours de la phase opératoire, c'est-à-dire en boucle fermée, pour chaque canal sélectionné.

Après sélection du canal "x" considéré, une étape d'initialisation Po est mise en oeuvre, comportant :
- une initialisation à zéro de variables C , I , ▲PREC, MEMO et DEFAUT, dont l'utilité sera vue ultérieurement,
- une application, au convertisseur numérique-analogique 7 (figure 1), d'une tension de consigne de valeur nulle, commandant l'application d'un gain de valeur nulle, pendant une durée brève t_{O} de l'ordre de 200 ms par exemple, pour stabilisation du syntoniseur au moment du changement de canal,
- une application au convertisseur numérique-analogique 7 (figure 1), de la tension de consigne Vcx lue dans la mémoire de tensions de consigne 82, à l'adresse indiquée par la mémoire de pointeurs 84 pour le canal "x" considéré,
- un déclenchement d'un délai de temporisation t₁ de l'ordre de 500 ms par exemple, pour stabilisation du syntoniseur après application de cette tension de consigne.

Sauf évolution du niveau relatif à ce canal depuis sa dernière sélection, ou depuis l'établissement de la table de pointeurs au cas où il s'agirait d'une première sélection, la tension de consigne VCx ainsi appliquée permet donc d'obtenir la valeur de sortie N_{SO} souhaitée.

Une étape de traitement P1 permettant de détecter la présence ou l'absence d'une telle évolution est alors mise en oeuvre, comportant :
- une incrementation de la variable I d'une unité,
- une mémorisation momentanée, pour la durée de cette étape, dans la mémoire vive 85 (figure 1), dite mémoire de de travail, de la valeur V'd disponible en sortie du convertisseur analogique-numérique 9 (figure 1), qui est de préférence une valeur moyenne sur un certain nombre d'échantillons numériques successifs de sortie de ce convertisseur, afin d'éviter une éventuelle prise en compte de parasites isolés dans le signal de sortie de la chaîne,
- une recherche de la valeur de tension détectée Vd stockée dans la mémoire de tensions détectées, la plus proche de cette valeur V'd et une détermination de l'écart ▲ADR entre l'adresse ADRVd correspondante et l'adresse de référence ADRVdo correspondant à la valeur nominale Vdo, c'est-à-dire à la valeur souhaitéee N_{SO},
- une comparaison de la valeur absolue | ▲ ADR | de cet écart d'adresse avec le pas d'adressage "p", égal à 1 dans l'exemple considéré.

Si la valeur absolue de cet écart d'adresse est détectée supérieure à 1, c'est-à-dire si l'on détecte la présence d'un écart (significatif) ce qui correspond à une évolution du canal "x" ainsi qu'évoqué ci-dessus, et en supposant la variable T égale à 1, la valeur de la variable I étant vérifiée par un test To au cours d'une étape de traitement P2 alors mise en oeuvre, une nouvelle valeur de tension de consigne Vc est déterminée, au cours d'une étape de traitement P3 suivante comportant :
- un calcul de l'adresse ADRVCx de cette nouvelle tension de consigne par addition à l'adresse ADRVCx de la tension de consigne en cours, fournie par la mémoire de pointeurs 84, de l'écart ▲ADR ainsi déterminé,
- une application de cette nouvelle valeur de tension de consigne Vcx au convertisseur numérique-analogique 7,
- un déclenchement d'un délai de temporisation t2 de 300 ms par exemple, pour stabilisation du syntoniseur,
- un retour à l'étape de traitement P1.

Si après mise en oeuvre de cette nouvelle étape de traitement P1, la valeur absolue de l'écart d'adresse est à nouveau détectée supérieure à 1, et en supposant maintenant la valeur I égale à 2, vérification également effectuée par le test To au cours de l'étape de traitement P2 alors mise en oeuvre, une étape de traitement P5 est mise en oeuvre comportant :
- une mise de la variable ▲ PREC à la valeur ▲ ADR en cours, afin de mémoriser cette valeur ▲ ADR pour les valeurs suivantes de I pour lesquelles la valeur absolue de l'écart d'adresse serait de nouveau détectée supérieure à 1,
- un déclenchement d'un délai de temporisation t₂ de 300 ms par exemple,
- un retour à l'étape de traitement P1, en l'occurrence pour une valeur de I égale à 3.

Si après mise en oeuvre de cette nouvelle étape de traitement P1, la valeur absolue de l'écart d'adresse est à nouveau détectée supérieure à 1, et en supposant maintenant la valeur I égale à 3, vérification effectuée par le test To au cours de l'étape de traitement P2, une étape de traitement P4 est alors mise en oeuvre, consistant en un test permettant de comparer, à une unité près (en plus ou en moins) pour tenir compte d'éventuels défauts de précision, l'écart d'adresse ainsi obtenu à celui ▲ PREC obtenu pour la valeur précédente de I, en l'occurrence la valeur 2, auquel cas, si une identité ( à une unité près ) est observée, l'étape de traitement P3 est à nouveau mise en oeuvre, et si une non-identité (à une unité près) est observée, l'étape de traitement P5 est à nouveau mise en oeuvre.

Le test réalisé au cours de la phase P4 permet d'éviter d'effectuer immédiatement une correction de la tension de consigne alors que l'évolution constatée est peut-être due à la présence de signaux parasites, ou bien encore au fait que l'ensemble de la chaîne n'est pas encore parfaitement stabilisé après une première correction de cette tension de consigne, compte-tenu de la rapidité de répétition des mesures exigée.

Le test de l'étape de traitement P4 peut également être utilisé, comme indiqué dans l'algorithme représenté à la figure 4, comme condition de passage à l'étape P5 pour la valeur I = 2 car, la variable ▲ PREC ayant été initialisée à zéro dans l'étape de traitement initiale PO, ce test conduit alors automatiquement à l'étape P5 (la valeur absolue de l'écart d'adresse étant en effet ici, par hypothèse, supérieure à 1) .

Dans le cas où la valeur absolue de l'écart d'adresse serait ainsi détectée supérieure à 1 au cours de six étapes de traitement P1 successives au cours desquelles seraient mises en oeuvre les unes et/ ou les autres des étapes P2, P3, P4, P5 , de la façon décrite ci-dessus, un test T1 effectué au cours de l'étape P2 oriente vers une étape de traitement P6 comportant une comptabilisation de trois cycles successifs de six telles étapes successives, par incrémentation de la variable DEFAUT d'une unité pour chaque cycle de six étapes, puis comparaison de cette variable à la valeur 3.

Au cas où cette dernière variable est supérieure ou égale à 3, une étape de traitement P7 est mise en oeuvre, comportant une signalisation de cet état, puis une étape de traitement P8 comportant un retour à l'étape de traitement P1 après déclenchement d'un délai de temporisation t3, de 3s par exemple, et réinitialisation de la variable I à zéro.

Dans le cas contraire, c'est-à-dire au cas où la variable DEFAUT serait inférieure à 3, l'étape de traitement P8 serait directement mise en oeuvre.

La signalisation mentionnée ci-dessus peut comporter une simple émission, par l'unité de traitement 81, d'un signal binaire, référencé D1 sur la figure 1, dont la valeur passe par exemple à "1" lorsque la variable DEFAUT devient égale à 3.

Cette signalisation comporte cependant avantageusement une émission d'un signal numérique référencé D2 sur la figure 1, représentatif de l'écart d'adresse ▲ADR en cause, ou une émission simultanée des signaux D1 et D2, ce qui correspond au cas illustré sur la figure 1.

La détection d'un signal D1 de valeur "1" dans l'exemple considéré conduit normalement à interrompre le fonctionnement de la chaîne. En pratique, la valeur "1" du signal D1 pouvant être obtenue pour différentes valeurs d'écart ▲ADR, une comparaison préalable de la valeur du signal D2, représentative de l'écart ▲ADR en cause, à une valeur limite, permet de n'interrompre ce fonctionnement que lorsque l'écart ▲ADR atteint cette valeur limite.

Ces différents modes de signalisation seront regroupés sous le terme général de signalisation de défaut de fonctonnement.

Dans le cas où la valeur absolue de l'écart d'adresse ▲ADR est détectée inférieure ou égale à 1, c'est-à-dire où l'on détecte l'absence d'écart (significatif), à l'issue de la mise en oeuvre d'une étape de traitement P1, une étape de traitement P9 est mise en oeuvre, comportant un test sur la réalisation d'une telle détection sur deux étapes de traitement P1 successives, par incrémentation de la variable C d'une unité à chaque orientation vers cette étape de traitement P9 puis comparaison de cette variable à la valeur 2.

En cas de réalisation d'une telle détection sur deux étapes de traitement P1 successives, l'adresse ADRVCx de la valeur de tension de consigne VCx en cours est enregistrée dans la mémoire de pointeurs 84, à l'adresse de celle-ci correspondant au canal "x" considéré, au cours d'une étape de traitement P10, comportant ensuite un retour à l'étape P1 par l'étape P8.

Pour signaler ce nouvel enregistrement, la variable MEMO est mise à 1 au cours de l'étape de traitement P10, et la condition décrite ci-dessus, définissant le test To effectué au cours de l'étape P2 et permettant d'orienter soit vers l'étape P3 soit vers l'étape P4 en fonction de la valeur de I est par ailleurs complétée par une deuxième condition, sur la variable MEMO, de telle sorte que l'étape P2 n'est suivie directement par l'étape P3 que lorsque la variable MEMO est égale à O et la variable I égale à 1, sinon est suivie par l'étape P4. La variable MEMO est en outre réinitialisée à zéro à chaque calcul d'une nouvelle valeur de tension de consigne effectué au cours de l'étape P3.

En cas de réalisation d'une telle détection sur deux étapes de traitement P1 successives, un retour à l'étape P1 est effectué, après déclenchement d'un délai de temporisation t4 de l'ordre de 300 ms.

Pour permettre au test effectué au cours de l'étape de traitement P9 de ne donner un résultat positif et donc de ne conduire à l'étape de traitement P10 que pour deux étapes de traitement P1 successives fournissant chacune un écart | ▲ADR | inférieur ou égal à 1, la variable C est réinitialisée à zéro au cours des étapes de traitement P2 et P10.

Pour permettre au test effectué au cours de l'étape de traitement P4 de ne donner un résultat positif, et donc de ne conduire à l'étape de traitement P3 qui inclut l'application d'une nouvelle valeur de tension de consigne au convertisseur 7, que lorsque deux étapes de traitement P1 consécutives effectuées pour une même valeur de tension de consigne appliquée ont fourni deux écarts | ▲ ADR | supérieurs à 1 et identiques (à une unité près), les étapes de traitement P3 et P9 comportent également une réinitialisation à zéro de la variable ▲ PREC.

La variable DEFAUT est en outre réinitialisée à zéro au cours de l'étape de traitement P10 car, le niveau de sortie étant alors redevenu correct, une valeur autre de la variable DEFAUT n'a plus de raison d'être.

On notera que toute sélection d'un nouveau canal intervenant au cours du déroulement de l'algorithme ainsi décrit est considérée comme prioritaire et entraine donc un retour à l'étape d'initialisation P0.

Ainsi qu'il vient d'être décrit, le procédé suivant l'invention permet donc d'appliquer automatiquement la valeur de tension de consigne nécessaire pour obtenir immédiatement, sauf évolution de la chaîne de traitement considérée, la valeur souhaitée en sortie de cette chaîne.

Le procédé suivant l'invention permet également, en cas d'écart détecté par rapport à cette valeur souhaitée, de déterminer automatiquement la valeur de tension de consigne à appliquer pour compenser immédiatement cet écart, d'où un temps de convergence réduit par rapport à la méthode dite par incréments.

Le procédé suivant l'invention permet également de détecter toute impossibilité de compensation, traduisant un défaut de fonctionnement qu'il convient de signaler.

## Revendications

1. Procédé de commande automatique de gain, pour amplificateur (2, 4, 5) à gain variable, destiné à maintenir le niveau du signal de sortie de cet amplificateur égal à un niveau souhaité (NSO), consistant à :
- appliquer à l'amplificateur une valeur courante du signal de commande de gain;
- mesurer le niveau de sortie de l'amplificateur, par un dispositif de mesure ayant une caractéristique non linéaire, et fournissant une valeur appelée niveau de sortie mesuré;
- détecter un éventuel écart (Δ ADR) entre le niveau de sortie mesuré (Vd) et un niveau fixé (VdO) qui est égal au niveau de sortie qui serait mesuré si la sortie de l'amplificateur fournissait le niveau de sortie souhaité (NSO);
- et, si cet écart n'est pas négligeable, corriger le signal de commande, de façon à réduire cet écart;
caractérisé en ce que pour corriger le signal de commande de façon à réduire cette différence, il consiste à :
- rechercher selon une première relation ayant été prédéterminée par un étalonnage, un niveau d'entrée (VE), ou une première valeur théorique du signal de commande (Vc), correspondant, en sortie de l'amplificateur, à un niveau de sortie mesuré égal à celui effectivement mesuré;
- puis rechercher selon une seconde relation ayant été prédéterminée par un étalonnage, une seconde valeur théorique du signal de commande (Vc), correspondant au niveau d'entrée (VE), respectivement à la première valeur théorique du signal de commande (Vc), ainsi déterminé; - mettre à jour la valeur courante de signal de commande (Vc) en prenant la seconde valeur théorique ainsi déterminée.

2. Procédé selon la revendication 1 caractérisé en ce qu'il consiste en outre à régler le gain de l'amplificateur (2, 4, 5) de façon à adapter la dynamique du signal de commande de gain de l'amplificateur à gain variable, à la dynamique du signal d'entrée.

3. Procédé selon l'une des revendications 1 et 2, caractérisé en ce qu'il comporte une mémorisation de ladite valeur courante, éventuellement mise à jour.

4. Procédé selon l'une des revendications 1 à 3, caractérisé en ce que ledit signal d'entrée comportant une pluralité de canaux ayant des variations de leur niveau indépendantes d'un canal à l'autre, il comporte une mémorisation de ladite valeur courante du signal de commande, pour chaque canal, pour applicaticn initiale, à chaque changement de canal.

5. Procédé selon l'une des revendications 1 à 4, caractérisé en ce que lesdites opérations de recherche et de mise à jour ne sont effectuées à la suite d'une opération de détection que si celle-ci détecte la présence d'un écart sensiblement égal à celui détecté lors de l'opération effectuée pour la même valeur courante appliquée, une nouvelle opération de mesure et une nouvelle opération de détection avec la même valeur courante étant répétées dans le cas contraire.

6. Procédé selon l'une des revendications 3 et 4, caractérisé en ce que dans le cas de mise à jour, ladite mémorisation n'est effectuée qu'après plusieurs détections consécutives d'absence d'écart pour ladite valeur courante mise à jour.

7. Procédé selon l'une des revendications 1 à 6, caractérisé en ce qu'il comporte une signalisation de défaut de fonctionnement au bout d'un nombre déterminé de détections consécutives de présence d'écart.

8. Dispositif pour la mise en oeuvre du procédé suivant l'une des revendications 1 à 7, caractérisé en ce qu'il comporte un processeur (8) qui reçoit, via un convertisseur analogique-numérique (9) le signal fourni par un moyen (10) de mesure du niveau du signal issu dudit amplificateur à gain variable (2, 4, 5), et qui fournit, via un convertisseur numérique-analogique (7) le signal à appliquer à l'entrée (C) de commande de gain de l'amplificateur à gain variable, et qui contient, en mémoire, ladite seconde relation donnant les variations du signal de commande de gain et ladite valeur courante du signal de commande.

9. Dispositif suivant la revendication 8, caractérisé en ce que ledit processeur contient également en mémoire (83, 83') ladite première relation donnant les variations du niveau de sortie mesuré et la valeur souhaitée du niveau de sortie mesuré.

10. Dispositif selon la revendication 8, caractérisé en ce que ladite seconde relation donnant les variations du signal de commande de gain étant établie sous forme discrète, et mémorisée dans une mémoire (82), la mémorisation de ladite valeur courante du signal de commande est obtenue au moyen d'un pointeur (84) indiquant l'adresse de cette mémoire contenant cette valeur courante.

11. Dispositif selon la revendication 9, caractérisé en ce que ladite seconde relation donnant les variations du niveau de sortie mesuré étant établie sous forme discrète et mémorisée dans une mémoire (83), la mémorisation de ladite valeur souhaitée du niveau de sortie mesuré est obtenue au moyen d'un pointeur (83') indiquant l'adresse de cette mémoire contenant cette valeur souhaitée.

12. Dispositif selon la revendication 11, caractérisé en ce que ledit écart entre le résultat de ladite mesure et la valeur souhaitée est constitué par l'écart entre l'adresse fournie par ledit pointeur (83') et l'adresse correspondant à la valeur discrète mémorisée dans ladite mémoire (83), la plus proche du résultat de ladite mesure.

13. Application du procédé selon l'une des revendications 1 à 7 ou du dispositif suivant l'une des revendications 8 à 12, à la commande automatique de gain d'un syntoniseur, notamment pour réseau de vidéocommunication, ledit syntoniseur (2) recevant en entrée (E) un multiplex de N signaux de télévision transmis chacun par modulation d'amplitude d'une porteuse de fréquence déterminée, et de niveau variable dans le temps et d'un canal à l'autre.

## Patentansprüche

1. Verfahren zur automatischen Verstärkungssteuerung für einen Verstärker (2, 4, 5) mit variablem Verstärkungsgrad, der den Pegel des Ausgangssignals dieses Verstärkers auf einem gewünschten Pegel (NSO) halten soll, wobei das Verfahren folgende Schritte aufweist:
- an den Verstärker wird ein laufender Wert des Verstärkungsgrad-Steuersignals angelegt,
- der Ausgangspegel des Verstärkers wird von einer Meßvorrichtung mit einer nicht-linearen Kennlinie gemessen, so daß ein gemessener Ausgangspegelwert geliefert wird,
- man erfaßt einen eventuellen Abstand (ΔADR) zwischen dem gemessenen Ausgangspegel (Vd) und einem festgelegten Pegel (VdO), der dem Ausgangspegel gleicht, welcher gemessen würde, wenn der Ausgang des Verstärkers den gewünschten Ausgangspegel liefern würde,
- man korrigiert das Steuersignal, um diesen Abstand zu verringern, wenn er nicht vernachlässigbar ist,
dadurch gekennzeichnet, daß zur Korrektur des Steuersignals, mit der dieser Abstand verringert werden soll, das Verfahren darin besteht:
- gemäß einer ersten Beziehung, die durch Eichung vorher festgelegt wurde, einen Eingangspegel (VE) oder einen ersten theoretischen Wert des Steuersignals (Vc) zu suchen, der am Ausgang des Verstärkers einem gemessenen Ausgangspegel gleich dem tatsächlich gemessenen Pegel entspricht,
- dann gemäß einer zweiten, durch Eichung vorher festgelegten Beziehung einen zweiten theoretischen Wert des Steuersignals (Vc) zu suchen, der dem Eingangspegel (VE) bzw. dem ersten theoretischen Wert des so bestimmten Steuersignals (Vc) entspricht,
- den laufenden Wert des Steuersignals (Vc) unter Verwendung des zweiten so bestimmten theoretischen Werts zu aktualisieren.

2. Verfahren nach Anspruch 1, dadurch gekennzeichnet, daß es darin besteht, außerdem den Verstärkungsgrad des Verstärkers (2, 4, 5) so zu regeln, daß die Dynamik des Verstärkungssteuersignals des Verstärkers mit variabler Verstärkung an die Dynamik des Eingangssignals angepaßt wird.

3. Verfahren nach einem der Ansprüche 1 und 2, dadurch gekennzeichnet, daß der laufende und ggf. aktualisierte Wert gespeichert wird.

4. Verfahren nach einem der Ansprüche 1 bis 3, dadurch gekennzeichnet, daß, wenn das Eingangssignal zahlreiche Kanäle besitzt, deren Pegelveränderungen von einem Kanal zum anderen unabhängig sind, der laufende Wert des Steuersignals für jeden Kanal zur ursprünglichen Anwendung bei jedem Kanalwechsel gespeichert wird.

5. Verfahren nach einem der Ansprüche 1 bis 4, dadurch gekennzeichnet, daß die Operationen der Suche und Aktualisierung nach einer Erfassungsoperation nur durchgeführt werden, wenn diese das Vorliegen eines Abstands erfaßt, der im wesentlichen dem bei der für denselben angewendeten laufenden Wert durchgeführten Operation erfaßten Wert gleicht, während ansonsten eine neue Meßoperation und eine neue Erfassungsoperation mit dem gleichen laufenden Wert wiederholt werden.

6. Verfahren nach einem der Ansprüche 3 und 4, dadurch gekennzeichnet, daß bei der Aktualisierung die Speicherung erst nach mehreren aufeinanderfolgenden Feststellungen eines nicht vorhandenen Abstands für den aktualisierten laufenden Wert erfolgt.

7. Verfahren nach einem der Ansprüche 1 bis 6, dadurch gekennzeichnet, daß es eine Signalisierung eines Betriebsfehlers nach einer vorbestimmten Anzahl von aufeinanderfolgenden Erfassungen des Vorliegens eines Abstands enthält.

8. Vorrichtung zur Durchführung des Verfahrens nach einem der Ansprüche 1 bis 7, dadurch gekennzeichnet, daß sie einen Prozessor (8) enthält, der über einen Analog-Digital-Wandler (9) das von einem Mittel (10) zur Messung des Ausgangssignalpegels des Verstärkers mit variablem Verstärkungsgrad (2, 4, 5) gelieferte Signal empfängt und über einen Digital-Analog-Wandler (7) das an den Verstärkungssteuereingang (C) des Verstärkers mit variablem Verstärkungsgrad anzulegende Signal liefert, und daß der Prozessor die zweite Beziehung gespeichert hält, die die Veränderungen des Verstärkungssteuersignals und des laufenden Werts des Steuersignals liefert.

9. Vorrichtung nach Anspruch 8, dadurch gekennzeichnet, daß der Prozessor weiter im Speicher (83, 83') die erste Beziehung enthält, die die Veränderungen des gemessenen Ausgangspegels und den gewünschten Wert des gemessenen Ausgangspegels liefert.

10. Vorrichtung nach Anspruch 8, dadurch gekennzeichnet, daß die zweite Beziehung, die die Veränderungen des Verstärkungssteuersignals liefert, in diskreter Form gegeben ist und in einem Speicher (82) abgespeichert ist, wobei die Speicherung des laufenden Werts des-Steuersignals mit Hilfe eines Zeiger (84) erhalten wird, der die Adresse dieses Speichers mit diesem laufenden Wert angibt.

11. Vorrichtung nach Anspruch 9, dadurch gekennzeichnet, daß die zweite Beziehung, die die Veränderungen des gemessenen Ausgangspegels liefert, in diskreter Form vorliegt und in einem Speicher (83) enthalten ist und daß die Speicherung des gewünschten Werts des gemessenen Ausgangspegels mit Hilfe eines Zeiger (83') erhalten wird, der die Adresse dieses Speichers angibt, der diesen gewünschten Wert enthält.

12. Vorrichtung nach Anspruch 11, dadurch gekennzeichnet, daß der Abstand zwischen dem Ergebnis der Messung und dem gewünschten Wert durch den Abstand zwischen der vom Zeiger (83') gelieferten Adresse und der Adresse gebildet wird, die dem diskreten und im Speicher (83) enthaltenen Wert entspricht, der dem Ergebnis der Messung am nächsten kommt.

13. Anwendung des Verfahrens nach einem der Ansprüche 1 bis 7 oder der Vorrichtung nach einem der Ansprüche 8 bis 12 auf die automatische Verstärkungssteuerung eines Tuners, insbesondere für ein Fernsehprogramm-Verteilungsnetz, wobei der Tuner (2) am Eingang (E) ein Multiplexsystem von N Fernsehsignalen empfängt, die je durch Amplitudenmodulation einer bestimmten Trägerfrequenz übertragen werden und je zeitlich und von einem Kanal zum anderen variable Pegel besitzen.

## Claims

1. Automatic gain control method for a variable gain amplifier (2, 4, 5) adapted to maintain the level of the output signal of said amplifier equal to a required level (N_{SO}), consisting in:
- applying to the amplifier a current value of the gain control signal;
- measuring the output level of the amplifier by means of a measuring device having a non-linear characteristic and supplying a measured output level;
- detecting any offset (ΔADR) between the measured output level (Vd) and a fixed level (Vdₒ) which is equal to the output level that would be measured if the output of the amplifier were to supply the required output level (N_{SO}); and
- if said offset is not negligible, correcting the control signal in such a way as to reduce said offset;
characterized in that to correct the control signal so as to reduce said difference, it consists in:
- using a first relationship having been predetermined by calibration, seeking an input level (VE), or a first theoretical value of the control signal (Vc), corresponding, at the output of the amplifier, to a measured output level equal to that actually measured;
- then, using a second relationship having been predetermined by calibration, seeking a second theoretical value of the control signal (Vc) corresponding to the input level (VE), respectively to the first theoretical value of the control signal (Vc), determined in this way; and
- updating the current value of the control signal (Vc) by taking the second theoretical value thus determined.

2. Method according to claim 1 characterized in that it further consists in adjusting the gain of the amplifier (2, 4, 5) in such a manner as to adapt the dynamic range of the gain control signal of the variable gain amplifier to the dynamic range of the input signal.

3. Method according to claim 1 or claim 2 characterized in that it comprises memorisation of said determined, possibly updated value.

4. Method according to any one of claims 1 through 3 characterized in that said input signals comprising a plurality of channels with their levels varying independently of one another, it comprises memorisation of said current value of the control signal for each channel for initial application on each change of channel.

5. Method according to any one of claims 1 through 4 characterized in that said determination and update operations are carried out after a detection operation only if the latter detects an offset substantially equal to that detected during the detection operation carried out for the same applied current value, a new measurement operation and a new detection operation with the same current value being repeated otherwise.

6. Method according to claim 3 or claim 4 characterized in that in the update case, said memorisation is effected only after several consecutive detections of absence of any offset for said updated current value.

7. Method according to any one of claims 1 through 6 characterized in that it comprises malfunction reporting at the end of a particular number of consecutive detections of the presence of an offset.

8. Device for implementing the method according to any one of claims 1 through 7 characterized in that it comprises a processor (8) which receives via an analogue-to-digital converter (9) the signal provided by means (10) for measuring the level of the output signal from said variable gain amplifier (2, 4, 5) and which supplies via a digital-to-analogue converter (7) the signal to be applied to the gain control input (C) of the variable gain amplifier and which contains in memory said second relationship giving the variations of the gain control signal and said current value of the control signal.

9. Device according to claim 8 characterized in that said processor further comprises in memory (83, 83') said first relationship giving the variations in the measured output level and the required value of the measured output level.

10. Device according to claim 8 characterized in that, said second relationship giving the variations of the gain control signal being established in discrete form and memorized in a memory (82), the memorizing of said current value of the control signal is obtained by means of a pointer (84) indicating the address of said memory containing said current value.

11. Device according to claim 9 characterized in that, said second relationship giving the variations of the measured output level being established in discrete form and memorized in a memory (83), the memorizing of said required value of the measured output level is obtained by means of a pointer (83') indicating the address in said memory containing said required value.

12. Device according to claim 11 characterized in that said offset between the result of said measurement and the required value is in the form of the offset between the address provided by said pointer (83') and the address corresponding to the discrete value memorized in said memory (83) nearest the result of said measurement.

13. Application of the method according to any one of claims 1 to 7 or of the device according to any one of claims 8 to 12 to the automatic control of the gain of a tuner, in particular for a videocommunication network, said tuner (2) receiving at its input (E) a multiplex of N television signals each transmitted by amplitude modulation of a carrier of a particular frequency and of level varying in time and from one channel to another.
